Europäisches Patentamt

European Patent Office

Office européen des brevets

(11) Publication number: **0 409 391 A2**

# EUROPEAN PATENT APPLICATION

(21) Application number: **90305879.0**

(22) Date of filing: **30.05.90**

(51) Int. Cl.⁵: **H01L 23/498**

The title of the invention has been amended (Guidelines for Examination in the EPO, A-III, 7.3).

(30) Priority: **01.06.89 JP 64760/89**

(43) Date of publication of application:
**23.01.91 Bulletin 91/04**

(84) Designated Contracting States:
**DE FR GB**

(71) Applicant: **SOMAR CORPORATION**
**11-2, Ginza 4-chome Chuo-ku**
**Tokyo 104(JP)**

(72) Inventor: **Kobayashi, Akira**
**9 Nishino, Menuma-machi**
**Osato-gun, Saitama-ken(JP)**

(74) Representative: **Allam, Peter Clerk et al**
**LLOYD WISE, TREGEAR & CO. Norman**
**House 105-109 Strandand**
**London WC2R 0AE(GB)**

(54) **Spacer tape for IC package.**

(57) A spacer suited to be rolled together with a film carrier having a multiplicity of longitudinally arrayed wiring patterns in a central portion thereof for the prevention of direct contact between adjacent layers of the rolled film carrier is disclosed, which includes a flexible, continuous tape formed of a synthetic resin, and a pair of parallel, longitudinally arranged rows of protrusions formed on each of the abverse and reverse sides of the tape. The paired rows of protrusions are transversely spaced apart from each other at a distance greater than the width of the wiring patterns of the film carrier but not greater than the width of the film carrier.

EP 0 409 391 A2

## SPACER TAPE

This invention relates to a spacer to be inserted between adjacent layers of a rolled film carrier.

Tape automated bonding (TAB) which is now increasingly used in IC packaging is a method including a number of steps of providing a long film carrier with sprocket holes, forimg a multiplicity of wiring pattern units on the film carrier to obtain a TAB tape, bonding IC chips to the TAB tape by inner lead bonding and encapsulating the bonded IC chips with a resin. The film carrier before and after mounting of IC chips is rolled on a reel for storage.

Thus, there is a danger that the wiring patterns are brocken or the IC chips encounter bonding failure during winding and unwinding of the film.

The present invention has been made in view of the above problems and provides a spacer suited to be rolled together with a film carrier having a multiplicity of longitudinally arrayed wiring patterns in a central portion thereof for the prevention of direct contact between adjacent layers of the rolled film carrier. The spacer comprises a flexible, continuous tape formed of a synthetic resin, and a pair of parallel, longitudinally arranged rows of protrusions formed on each of the abverse and reverse sides of said tape, said pair of rows being transversely spaced apart from each other at a distance greater than the width of the wiring pattern of the film carrier but not greater than the width of the film carrier.

In the present specification and appended claims, the term "film carrier" is intended not only to mean the final TAB tape on which IC chips have been bonded and, if desired, encapsulated but also to refer to any other intermediate product prior to mounting of IC chips, such as a TAB tape having wiring patterns on which IC chips are to be mounted or a tape on which a copper foil is laminated. Thus, the spacer according to the present invention is utilized to any rolled tape or film used in tape automated bonding processes.

The present invention will now be described in detail below with reference to the accompanying drawings, in which:

Fig. 1 is a partial plan view diagrammatically showing one embodiment of a spacer according to the present invention;

Fig. 2 is a perspective view of the spacer of Fig. 1 in a longitudinally bent state;

Fig. 3 is a partial, sectional view schematically showing the spacer of Fig. 1 as rolled together with a film carrier;

Fig. 4 is a partial plan view similar to Fig. 1 diagrammatically showing another embodiment according to the present invention;

Fig. 5 is a side view of Fig. 4; and

Fig. 6 is a partial, enlarged, perspective view of the spacer of Fig. 4 with one insertion member being detached for explanation purposes.

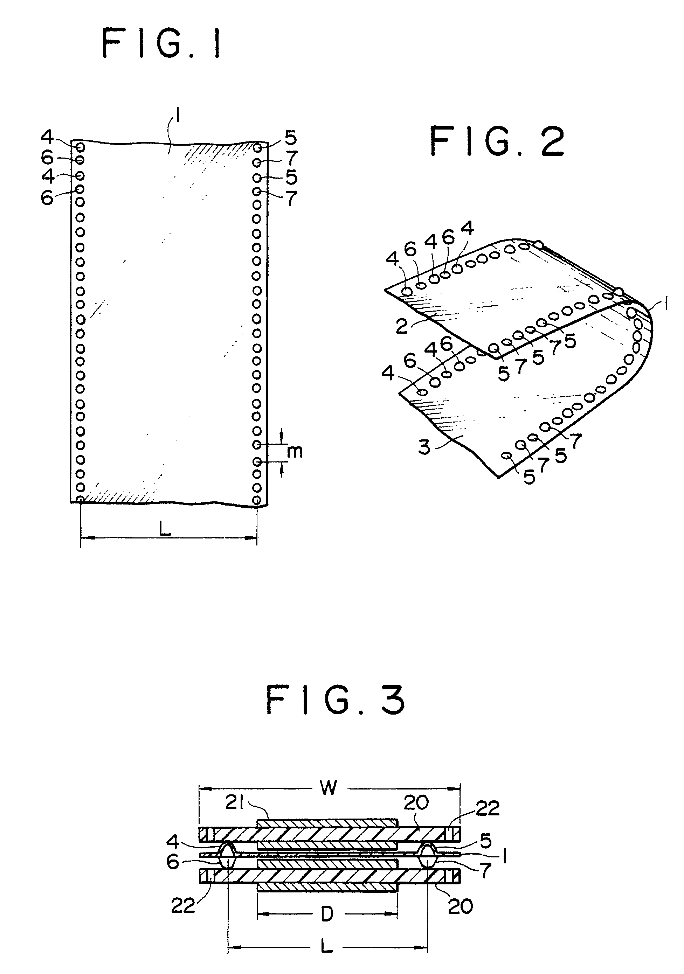

Figs. 1 and 2 depict spacer of the present invention which is composed of a flexible, continuous tape 1 formed of a synthetic resin. The tape 1 has a multiplicity of embossed protrusions along both side portions of each of the abverse and reverse surfaces 2 and 3 thereof. More particularly, a pair of parallel, first and second longitudinal rows of the protrusions 4 and 5 are formed on the abverse side 2 of the tape 1, while another pair of similar rows of protrusions 6 and 7 are formed on the other side 3 of the tape 1. In the preferred embodiment shown, the protrusions 4 and 6 are alternately formed linearly in a row and the protrusions 5 and 7 are also alternately arranged linearly in a row, with a distance "m" between adjacent protrusions being preferably 5-20 mm.

These protrusions 4 through 7 may be formed by embossing the tape 1 using any known press molding machine and, preferably, by feeding the tape 1 through a pair of embossing rolls. For reasons of facilitating the embossing treatment, it is preferred that the tape 1 be formed of a thermoplastic resin such as a polyester resin, a polyamide resin or a polyvinyl chloride resin. The shape of the protrusions 4 through 7 is not specifically limited but is preferably in a semispherical form having a radius of 1-5 mm. The height of the protrusions depends on the kind of the film carrier to which the spacer is applied and is so determined as to become greater than the height of the wiring patterns or IC chips mounted on the patterns.

Fig. 3 schematically illustrate a state of the above spacer in use wherein the spacer is rolled together with a film carrier. Designated as 20 are layers of the rolled film carrier having a multiplicity of longitudinally arranged wiring patterns 21 in a middle portion thereof. Respective film carrier layers 20 are separated by layers of the spacer. Because of the presence of protrusions 4 through 7 on both sides of the spacer, the wiring pattern units 21 of respective adjacent layers 20 are suitably prevented from being rubbed or damaged. Further, even if the film carrier bears IC chips mounted on the wiring pattern units, the thickness of thereof do not cause problems as long as th height of the protrusions 4 through 7 is sufficiently greater than the thickness of the IC chips. Designated as 22 are sprocket holes provided in both side end portions of the film carrier.

In order for the protrusions 4 through 7 can function properly, it is important that rows of the protrusions should be transversely spaced apart from each other at a distance L which is greater than the width D of the wiring pattern units 21 of the film carrier but not greater than the width W of the film carrier. When the size of the protrusions is greater than the diameter of the sprocket holes 22, the distance L may be equal to the distance between the laterally spaced apart sprocket holes 22. When the size of the protrusions is so small that they are able to be inserted through the sprocket holes 22, then the distance L is determined so as to differ from the distance between the rows of the sprocket holes 22.

Since film carrier used in TAB mounting is formed of a synthetic polymer, it often encounters problems relating to static electricity. Such problems may be effectively overcome by the use of a spacer of the present invention in which the tape 1 is formed of an electrically conducting material. Thus, in a preferred embodiment according to the present invention, the tape 1 is formed of a composition containing a thermoplastic synthetic resin and carbon powder in an amount sufficient to render the tape 1 electrically conductive.

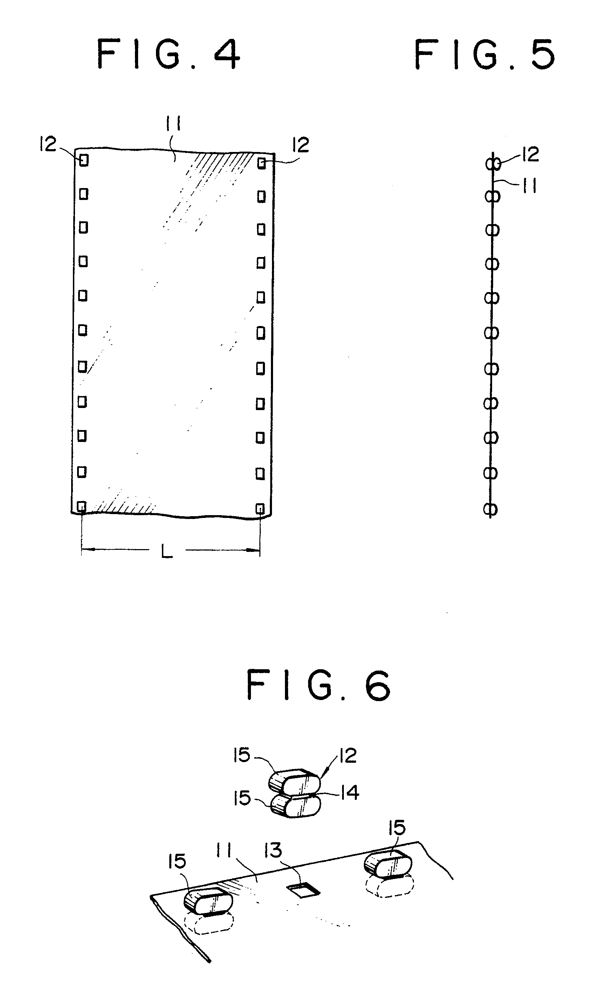

Figs. 4 through 6 illustrate a further embodiment of spacer according to the present invention which is suitably used for a film carrier having a high surface temperature. Designated as 11 is an elongated tape preferably formed of a heat-resisting resin. The tape 11 has a pair of parallel, longitudinal rows of perforations 13 in both side end poritions thereof. A dumbbell-like shape insertion 12 is secured in each of the perforations 13 with its neck portion 14 being inserted therein and with its both large diameter end portions 15 serving to function as the protrusions 4-7 in the above-described first embodiment shown in Figs. 1-3. The distance L between the paired rows of perforations 13 (namely the insertions 12) is determined in a similar manner as that of the above-described first embodiment. The height of the protrusions 12 from the surface of the tape 11 and other dimensional aspect associated with the protrusions 12 are generally the same as those in the above-mentioned first embodiment.

The insertions 12 are formed of a heat-resisting resin material so that they can withstand high temperature conditions created when a film carrier to which the spacer is applied has a high temperature, for example, when the film carrier is as just laminated with a copper layer by a thermal-press method. The thermal stability of the spacer is of course improved when the tape 1 too is formed of a heat-resisting material. Suitable heat-resisting resins include, for example, polyetherimides, polyimides, polyaryl amides and polyvinylidene fluoride.

The spacer shown in Figs. 4-6 may be prepared by automatically or manually inserting the insertions 12 into the perforations 13 of the tape 11. An elasticity of the resin tape 11 permits insertion of the dumbbell-like members 12 having portions 15 which are larger than the diameter of the perforations 13. The dumbbell-like insertions 12 may be obtained by injection molding or by first forming, by extrusion, a columnar member and then cutting same into sections.

In the above embodiments the thickness of the tape 1 or 11 is not specifically limited as long as it can be rolled together with a film carrier. Generally, the thickness is in the range of 50-500 $\mu$m, preferably 75-250 $\mu$m. The width of the tape 1 or 11 varies with the film carrier to be employed and is generally the same as or slightly smaller than that of the film carrier.

The invention may be embodied in other specific forms without departing from the spirit or essential characteristics thereof. The present embodiments are therefore to be considered in all respects as illustrative and not restrictive, the scope of the invention being indicated by the appended claims rather than by the foregoing description, and all the changes which come within the meaning and range of equivalency of the claims are therefore intended to be embraced therein.

## Claims

1. A spacer suited to be rolled together with a film carrier having a multiplicity of longitudinally arrayed wiring patterns in a central portion thereof for the prevention of direct contact between adjacent layers of the rolled film carrier, said spacer comprising a flexible, continuous tape formed of a synthetic resin, and a pair of parallel, longitudinally arranged rows of protrusions formed on each of the abverse and reverse sides of said tape, said pair of rows being transversely spaced apart from each other at a distance greater than the width of the wiring patterns of the film carrier but not greater than the width of the film carrier.

2. A spacer as set forth in claim 1, wherein said protrusions have been formed by embossing said tape.

3. A spacer as set forth in claim 2, wherein said tape is formed of a polyvinyl chloride resin, a polyester resin or a polyamide resin.

4. A spacer as set forth in claim 2, wherein said tape is electrically conducting.

5. A spacer as set forth in claim 4, wherein said tape contains carbon powder dispersed in the synthetic resin.

6. A spacer as set forth in claim 2, wherein the protrusions of each of said rows are alternately protruded in opposite directions from said tape.

7. A spacer as set forth in claim 1, wherein said tape has a pair of rows of perforations to each of which an insertion in a dumbbell-like form is secured with its neck portion being inserted therein and with its both large diameter end portions serving as said protrusions.

8. A spacer as set forth in claim 7, wherein said insertions and/or said tape are formed of a heat-resisting resin material.

9. A spacer as set forth in claim 8, wherein said heat-resisting resin is a polyetherimide, a polyimide, a polyaryl amide or a polyvinylidene fluoride.

10. A spacer as set forth in claim 7, wherein said tape is electrically conducting.

11. A spacer as set forth in claim 10, wherein said tape contains carbon powder dispersed in the synthetic resin.

# FIG. 1

# FIG. 2

# FIG. 3

# FIG. 4

# FIG. 5

# FIG. 6